# EUROPEAN PATENT APPLICATION

(11) **EP 2 293 435 A1**
(43) Date of publication of application: **09.03.2011**
(21) Application number: 09168468.8
(22) Date of filing: 24.08.2009
(51) Int. Cl.: H03F 1/30, H03F 1/56, H03F 3/193

(54) **Power amplifier, base station and method for power amplification of an RF signal in a communication network**

(71) Applicant: Alcatel Lucent, 75007 Paris (FR)
(72) Inventor: Wiegner, Dirk, 71409 Schwaikheim (DE); Jüschke, Patrick, 75428 Illingen (DE)
(74) Representative: Kohler Schmid Möbus

(57) **Abstract**

The present invention relates to a power amplifier configured for amplifying an RF signal in a communication network. The power amplifier (A; 4) comprises an RF signal input terminal (IN) for inputting an RF input signal (RFin) to be amplified by the power amplifier (A; 4), an RF signal output terminal (OUT) for outputting an amplified RF output signal (RFout), and at least one tunable or configurable element (GB, DB). A neural network (NN; 10) is coupled to the power amplifier (A; 4), receives at least one input parameter (IP1 to IP5) and is configured to steer said at least one tunable or configurable element (GB, DB) on the basis of the input parameter (IP1 to IP5). The invention also relates to a base station and to a communication network comprising at least one such power amplifier (A; 4), and to a method for power amplification of an RF signal in a communication network.

## Description

### Field of the Invention

The present invention relates to a power amplifier, a base station, a wireless communication network and a method for power amplification of an RF signal in a communication network.

### Description of Related Art

This section introduces aspects that may be helpful in facilitating a better understanding of the invention. Accordingly, the statements of this section are to be read in this light and are not to be understood as admissions about what is in the prior art or what is not in the prior art.

Currently, several important parts of a conventional base station are fixed or in best case controlled by a central unit which in most conventional base stations controls the components through different layers, making the controlling difficult. As the controlled parts cannot react autonomously on different scenarios, the best performance will often not be achieved.

Typically, power amplifiers in commercially available base stations are designed as conventional class-AB based amplifiers with fixed supply voltage and a matching network matched for a single standard application working in base stations with fixed set-ups due to the specific requirements, as are carriers, frequency ranges, power class, and so on. The solutions based on class-AB amplifiers only achieve moderate efficiency for fixed supply voltage with clear efficiency decrease for increased back-off operation, e.g. when signal peak-to-average increases for example in case of multi-standard operation or in case of night and day load scenarios. For example, in the night there is usually less load on the base station than in the mid of the day. It is therefore very desirable to improve efficiency and performance of power amplifiers, base stations and radio communication networks operating with such base stations as well as to increase flexibility and self-adaptability for example for advanced support of multi-standard and multi-band applications like software-defined radio or cognitive radio, location-based autonomous set-up, and so on.

### Summary of the Invention

It is therefore an object of the present invention to provide a power amplifier, a base station and even a whole RF communication network in which efficiency and performance can be improved and flexibility can be increased and which achieve self-adaptability.

An underlying concept of the invention is to create an intelligent power amplifier, a complete base station or even an RF communication network that have different tunable elements allowing tuning and adapting the power amplifier or base station(s) to different scenarios, possibly while the power amplifier and base station is/are working and learning about the conditions in the specific location and specific requirements. Such learning and adapting procedures lead to a more optimized performance of e.g. the amplifier or the whole base station and/or the RF communication network and additionally lead to a certain predictability of operating conditions, allowing to adapt and optimize the power amplifier's or base station's suitability and accurate timing.

According to a first important aspect of the invention, the above object is solved by a power amplifier configured for amplifying an RF signal in a communication network, said power amplifier comprising an RF signal input terminal for inputting an RF input signal to be amplified by said power amplifier, an RF signal output terminal for outputting an RF output signal amplified by said power amplifier, and at least one tunable or configurable element, wherein said power amplifier further comprises or is coupled with at least one neural network configured to steer said at least one tunable or configurable element on the basis of at least one input parameter input to said at least one neural network.

Thus, the core of the intelligent (brain-based) power amplifier and base station according to the invention may be devised as one or more neural networks. These neural networks typically receive several input parameters which are processed to steer several tunable or adaptable or configurable elements of the power amplifier or base station, respectively. The neural networks will learn before and/or while they are working. The learning may be performed by providing the RF output signal of the power amplifier, a property derived from the RF output signal, or other outputs of the neural network as input parameters to the neural network, thus providing a feedback about the quality of the amplifier tuning. It may also be possible to use a network type being known as a feedback network, a feedback from the outputs to the inputs of the network is provided per-se, such that no additional (external) feedback may be required.

In any case, the neural networks may learn about the different requirements, for example for different scenarios, know about the current daytime and thus can control the power amplifier or base station with their newest knowledge. Thus, the amplifier or base station adjust themselves independently in the specific environment and can thus optimize the tunable or adaptable or configurable parameters according to the specific conditions.

If components of the base station like the power amplifier are equipped with such a neural network, a complex controlling through different communication layers will be clearly relaxed or can even be omitted due to the self-adaptation of the power amplifier by means of its neural network.

In an advantageous development of the power amplifier the at least one tunable or adaptable or configurable element comprises at least one or more of the following: power amplifier's gate biasing, power amplifier's drain biasing, and switchable or tunable RF signal impedance and/or frequency matching network(s). Typically, the power amplifier comprises at least one power transistor (Field Effect transistor), the Gate and/or the Drain terminal thereof being controlled by a (DC) bias signal through a Gate/Drain biasing element. In particular, a modulator may be used for providing an adaptive supply voltage to the Drain terminal, the supply voltage being dependent e.g. on an envelope of the RF input signal, in particular when the power amplifier is used in an Envelope Tracking, ET, or Envelope Elimination and Restoration, EER, configuration. The switchable or tunable impedance matching networks may comprise at least one switchable element (e.g. PIN diodes or MEMS switches) for activating/deactivating one or more fixed impedance matching elements (capacitors having fixed impedance etc.). Alternatively or in addition, at least one tunable element, for instance a tunable capacitor (with variable impedance) may be provided. Both the switchable and tunable element(s) may be controlled/steered by the at least one (artificial) neural network.

Further advantageously, the at least one input parameter input to the at least one neural network comprises one or more of the parameters: RF input signal, RF output signal, number of RF carriers, number of signal channels, current load, signal properties, signal envelope, and time, e.g. time of day / night / clock. Specific properties of the current input/output RF signal may include its center frequency, its peak-to-average ratio, and the signal standard. Also, the time (of day) may be used as an input to the neural network in order to adapt the power amplifier to different load scenarios (daytime / nighttime).

Further advantageously, the at least one neural network is configured to decide based on the input parameters about a required amplifier configuration by controlling the at least one tunable or adaptable or configurable element. For this purpose, the output(s) of the neural network are provided to the tunable or configurable element(s). The decision about the required amplifier configuration is made in dependence of the current input parameters applied to the network and on a state of the neural network which is represented by the weights of the connections between the nodes of the neural network. It will be understood that before operation, the neural network may be trained using input parameter sets which should be mapped to specific output parameter sets for given (predefined) amplifier configurations, the deviation between the outputs produced by the network and the given output parameter sets being used for adapting the weights of the network accordingly as is known in the art (back-propagation). Moreover, the at least one neural network may be configured to learn about current conditions or scenarios of the power amplifier and will be able to recognize conditions or scenarios for the future based on the at least one input parameter. This is possible as the weights of the connections between the nodes are adapted dynamically and as feedback about the output(s) of the neural network is provided to the inputs of the neural network. When a neural network type is used which does not provide an internal feedback, an external feedback path may be provided for performing the self-learning, e.g. providing the RF output as an input to the network.

According to a second aspect the above object is solved by a base station comprising at least one (intelligent) power amplifier according to the invention as specified above.

The base station advantageously may further comprise one or more of the following functional units: a baseband signal processing unit, a digital signal processing unit, a digital-to-analogue up-conversion unit, an analogue-to-digital down-conversion unit, a filter, resp., a filter network unit, a Low-Noise amplifier, and said at least one neural network may be coupled to the base station and configured for steering the at least one additional functional unit.

Further, the above object is solved according to a third aspect of the invention by a communication network comprising at least two base stations as defined above, wherein these base stations are configured to communicate together in the RF communication network.

Further, a communication network according to the present invention may comprise at least two base stations configured to communicate together and at least one neural network coupled to said at least two base stations and configured to tune or to configure said base stations on the basis of at least one input parameter input to the at least one neural network.

Further, the above object is solved according to a fourth aspect by a method for power amplification of an RF signal in a communication network, comprising steps of inputting an RF input signal to be amplified; outputting an amplified RF output signal, and tuning or configuring at least one tunable amplification parameter in accordance with at least one input parameter, wherein said tuning, or configuring of said at least one tunable amplification parameter is carried out by steering it by means of at least one neural network on the basis of said at least one input parameter input to said at least one neural network.

Advantageously in the present method for power amplification, the at least one tunable amplification parameter comprises at least one parameter selected from the group of: power amplifier's gate biasing modulation parameter(s), power amplifier's drain biasing modulation parameter(s), and switchable or tunable RF signal impedance / frequency matching parameters. Thus, the amplifier biasing and/or the input/output impedance of the power amplifier may be optimized/adapted for different amplifier configurations. It will be understood, however, that when more sophisticated amplifier types such as digital amplifiers (e.g. of Class-s type) are used, different/further amplifier parameters may be adjustable. For example, when a Class-S concept is used, modulator parameters of a delta-sigma or a pulse-length modulator e.g. in combination with a self-linearization of the Class-S amplifier may be adjusted under control of the neural network. Additionally, paramters such as biasing of the switch-mode stage (e.g. in Class-D configuration) could be controlled and optimized for the current operation conditions by the neural network.

Further advantageously in the present method, the at least one input parameter to the at least one neural network comprises one or more parameters such as RF input signal, RF output signal, number of RF carriers, number of signal channels, current load, signal properties, signal envelope, and time. The number of RF carriers / signal channels, and, in particular, their respective center frequencies may be used to perform adaptive frequency matching of corresponding frequency matching elements using the neural network. It will be understood that also parameters different from those cited above may be provided as input parameters to the neural network.

Further advantageously in the present method for power amplification, the at least one neural network decides based on the input parameters about a required amplification configuration by controlling the at least tunable or adaptable or configurable parameter. To be more precise, typically the output(s) of the neural network will represent a weighted sum of the input parameters, the weights being defined for each of the connections between two nodes of different layers of the network.

Last but not least in the present method for power amplification, the at least one neural network learns about current conditions or scenarios and recognizes conditions or scenarios for the future based on the at least one input parameter. Typically, after training the neural network by using a plurality of training parameter sets for specific conditions or scenarios, the neural network will be able to adapt to other, similar scenarios for which the neural network has not been trained, resulting in an (almost) optimum performance also for these un-trained scenarios or conditions. Moreover, a dynamical adjustment / learning of the neural network may be performed, in particular when feedback about the quality of the adjustment is provided to the neural network, for example in the form of at least one input parameter which is related to at least one property of the amplified RF signal, or when the neural network itself provides a feedback from its output(s) back to its input(s).

The inventive idea as specified above is not only suitable for the power amplifier. It is moreover possible to control more parts, maybe the whole base station by one or several neural networks. It is also suitable to let the base stations communicate and get a neural network which is adapted to steer configurable elements being arranged in different base stations.

### Brief Description of the Drawings

In the following description a number of exemplary embodiments of an inventive (intelligent) power amplifier, base station, communication network and method of power amplification of an RF signal in a communication network will be described in detail with reference to the following figures, wherein:
- Fig. 1: schematically shows an embodiment of the intelligent power amplifier line-up controlled by a neural network;
- Fig. 2: schematically shows the principle configuration of a neural network with a number of exemplary possible input parameters and output parameters for an intelligent power amplifier;
- Fig. 3: schematically shows a block diagram of functional units of a base station transceiver in a base station according to the present invention, and
- Fig 4: schematically depicts a number of base stations each being adaptively controlled by its own neural network and being configured to communicate together, thus forming an example of a communication network according to the invention.

### Detailed Description of the embodiments

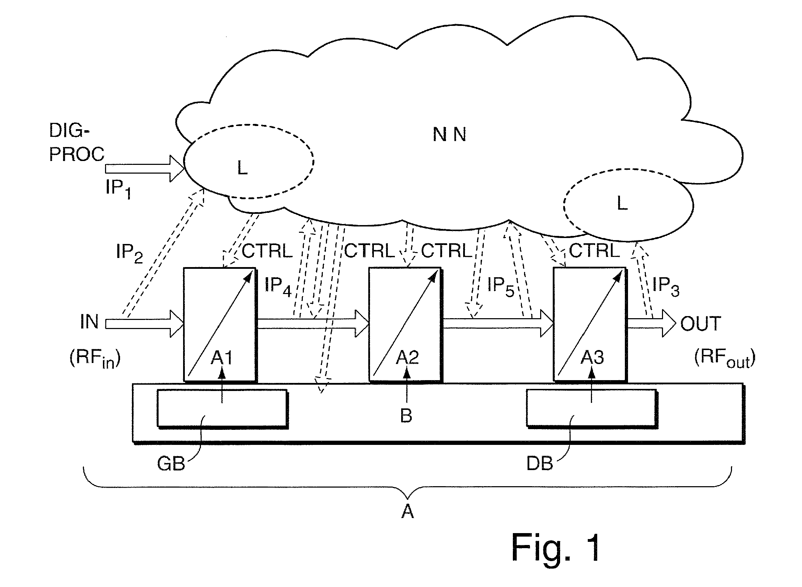

The schematic diagram of **Fig. 1** shows an embodiment of an intelligent power amplifier A having, in the present example, three amplifier stages A1, A2, A3. The first amplifier stage is a pre-amplifier stage (comprising matching networks and transistors) and receives an RF input signal "RFin" input through an RF input terminal IN. The first amplifier stage A1 is connected to the second amplifier stage A2 which is devised as a driver amplifier stage (comprising matching networks and transistors). From there, the RF signal is further lead to a final (output) amplifier stage A3 where it is provided as an output signal "RFout" through an output terminal OUT.

It will be understood that when the intelligent power amplifier A is devised as a digital power amplifier, e.g. as a class-S amplifier, the first amplifier stage A1 may be devised as a Delta-Sigma- or pulse-width modulator, the second amplifier stage A2 may be devised as a switching stage (class-D amplifier stage including power transistor(s) and matching lines), and the third amplifier stage may be devised as a reconstruction filter.

The embodiment of the power amplifier A further comprises a biasing unit B including a gate biasing unit GB and a drain biasing unit, e.g. comprising a bias modulator DB or a switching unit for adapting the bias voltage to e.g. different load conditions (daytime / nighttime). The gate biasing unit GB has the function of generating a gate bias for one, two or all amplifier stages A1, A2, A3. The drain bias modulator DB is configured to generate e.g. a modulated or switched drain bias which is applied to a drain terminal of one, two or all amplifier stages A1, A2, A3 of the brain based power amplifier A. At least one element of the amplifier A, for example, the gate biasing unit GB and/or the drain bias unit, e.g. comprising a bias modulator DB are configured as tunable or adaptable or configurable element(s). The intelligent power amplifier A further comprises or is coupled with a neural network NN which is represented in Fig. 1 by curved lines like a cloud.

The neural network NN gets input parameters IP1 from a digital signal processing unit DIG-PROC and further input parameters IP2, IP3 which are derived from the input signal RFin and the RF output signal RFout, respectively. Furthermore, the neural network NN gets input parameters IP4, IP5 from the outputs of the first and second amplifier stages A1, A2 for specifically controlling these stages independently from the third stage A3. The input parameters designated with reference numbers IP1 to IP5 may relate to input parameters such as the time/clock, input signal RFin, output signal RFout, the number of carriers of the signal, the number of channels of the signal, the current load, and so on.

These input parameters are processed in the neural network NN to steer at least one of the tunable or adaptable or configurable elements of the power amplifier A. The neural network NN will learn while it is working. The type of learning depends on the type of application and on the amplifier type (power amplifier, transceiver, etc.). Typically, reinforcement learning or unsupervised learning is used. Unsupervised learning, which is in general provided by so-called Kohonen networks, has been proven to be advantageous in combination with a power amplifier. The learning function is surrounded by broken lines and indicated by the letter "L". The neural network NN learns about the different requirements e.g. for different scenarios, knows about the current daytime and can thus control the tunable or adaptable or configurable element(s) in dependence of the input parameters IP1 to IP5. Apart from the Gate biasing unit GB and the Drain biasing modulator DB of the power amplifier A, the tunable or adaptable or configurable elements may form part of impedance or frequency matching networks provided for impedance/frequency matching of the respective amplifier stages A1 to A3. The control functions of the neural network NN are indicated in Fig. 1 by respective arrows in broken lines and designated as "CTRL".

Thus, the power amplifier A is adapted to adjust itself independently in its specific environment and can optimize tunable / adaptable / configurable parameters of the at least one tunable or configurable element to the specific conditions. Since the power amplifier A comprises its own neural network NN, a complex controlling through different communication layers will be clearly relaxed or can even be omitted due to the self-adaptation of the power amplifier A by the neural network NN.

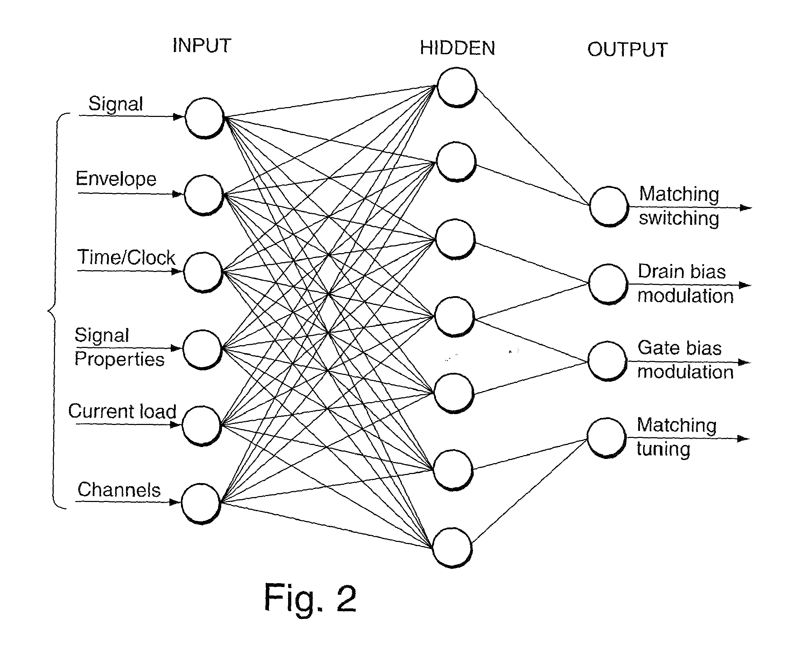

**Fig. 2** shows the schematic of the configuration of an exemplary (feed-forward) neural network NN suitable for use in the present invention and having three layers of nodes, respectively devised as an input layer, a hidden layer and an output layer. The nodes at the input side / layer represent the receiving nodes for the input parameters as mentioned above, in particular (RF) signal, envelope, time/clock, signal properties, current load, channels, and so on. The nodes at the output side / layer represent the controlling or steering functions of the tunable or adaptable or configurable elements, such as a matching function for one or more switching or tunable element(s) being provided e.g. in adjustable impedance/frequency matching networks, for drain bias modulation or bias switching, for gate bias modulation or bias switching, etc. As described above, the switching/tuning elements may be adapted for frequency and/or impedance matching of one or more of the respective amplifier stages A1 to A3.

One of ordinary skill in the art will readily recognize that the schematic representation of the neural network NN in Fig. 2 is only a simplified example of a neural network suitable for the intelligent power amplifier A shown in Fig. 1. Other configurations of a neural network suitable for the present invention and having more or less or other input parameters or nodes and more or less or other output nodes as are shown in Fig. 2 are conceivable. In particular, the neural network NN may also comprise a larger number of nodes in the hidden layer, or may comprise more than one hidden layer.

The principle of an intelligent steering, control or tuning is not only suitable for a power amplifier A as it is presented above. The present invention can also be applied to control more parts, e.g. a whole base station or even a whole RF communication network by one or more neural networks.

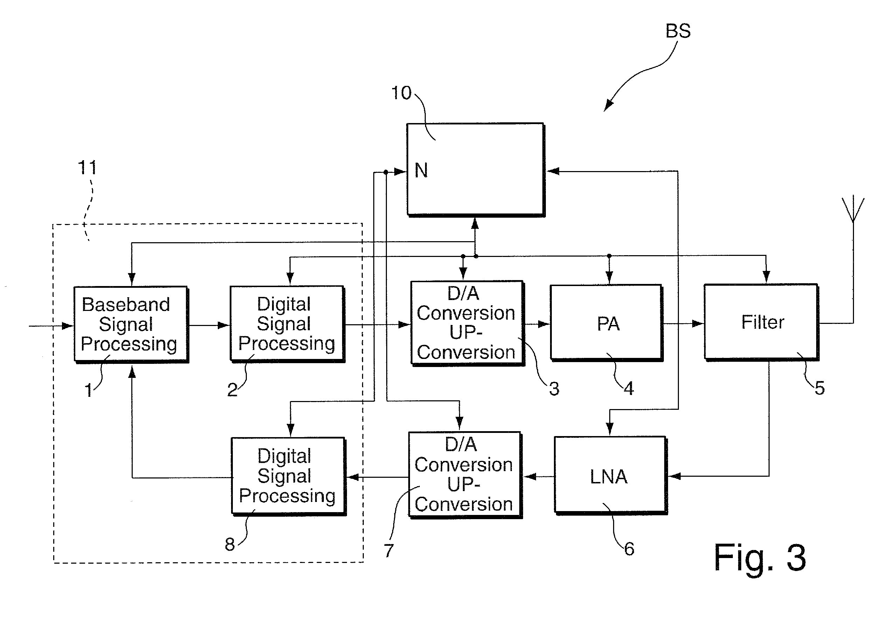

**Fig. 3** shows a functional block diagram of an embodiment of a base station transceiver BS (transceiver frontend) having functional units, such as a baseband signal processing unit 1, digital signal processing units 2 and 8, a digital-to-analogue frequency up-conversion unit 3, an analogue-to-digital and frequency down-conversion unit 7, a power amplifier 4, a filter unit 5 and a low-noise amplifier, LNA 6. The digital signal processing units 2, 8 may be combined with the baseband signal processing unit 1 in a baseband digital signal creation and processing unit 11, as indicated by a dashed line in Fig. 3. This transceiver is further coupled with or comprises a neural network (NN) 10 configured to steer at least one tunable or configurable element of the baseband signal processing unit 1, the digital signal processing units 2, 8, the D/A and A/D conversion units 3, 7, the power amplifier 4, the filter unit 5 and the LNA 6 on the basis of input parameters input to said neural network 10. These input parameters may comprise the input parameters shown in Fig. 2 or more or less or other input parameters not being indicated in Fig. 2.

The transceiver frontend BS comprises a RF signal path from the baseband signal processing unit 1 to the filter 5 from which the amplified RF signal is provided to an antenna element for performing RF transmissions. Furthermore, a feedback path is provided in the transceiver BS, leading e.g. from the output of the power amplifier 4, or from the output of the filter 5 back to a digital signal processing unit 8 of the baseband digital signal creation and processing unit 11, the feedback being used for performing digital pre-processing of the RF signal to achieve a better linearization of the RF signal at the output of the power amplifier 4. It will be understood that the transceiver BS may also be devised without the feedback path of Fig. 3, and, in particular, other types of feedback may be used for performing e.g. a linearization of the amplification of the RF input signal "RFin".

In any case, the embodiment of the transceiver frontend BS shown in Fig. 3 has one or more tunable or adaptable or configurable elements in one or more of the functional units 1 to 8, and the neural network 10 is configured to tune, adapt or configure the whole transceiver BS to different scenarios during operation of the base station, and in particular learning about the conditions in the specific location and specific requirements. The learning and adapting procedures of the neural network 10 lead to a more optimized performance of the whole transceiver BS and additionally lead to a certain predictability of operating conditions allowing to adapt or optimize the base station's suitability for the RF communication and accurate timing.

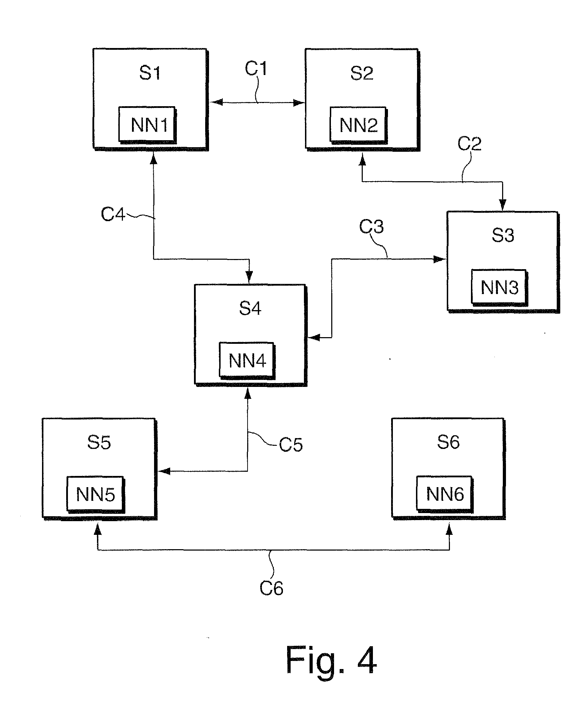

**Fig. 4** schematically shows a functional block diagram of an exemplary communication network communicating through a plurality of base stations S1-S6 respectively comprising their own neural network NN1 - NN6 and transceivers (not shown). The base stations are configured to communicate together by means of communication channels C1 - C6, being implemented as wireless or wire-line (cable, fiber optical etc.) connections. For example, the base station S1 communicates with the base station S2 through a first communication channel C1, the base station S2 communicates with base station S3 through a second communication channel C2, the base station S3 communicates with base station S4 through a third communication channel C3, base station S4 communicates with base station S1 through a fourth communication channel C4, the base station S4 communicates with base station S5 through a fifth communication channel C5 and the base station S5 communicates with base station S6 through a sixth communication channel C6.

Evidently, other communication configurations than represented in the example of Fig. 4 are conceivable. While in the embodiment of the communication network shown in Fig. 4 each base station BS1 - -BS6 comprises its own neural network NN1 - NN6, in alternative embodiments of a communication network, at least one neural network may be provided for steering tunable or adaptable or configurable elements of a plurality of base stations.

The skilled person will easily recognize that the present invention is also directed to a method for power amplification of an RF signal in a communication network, that method comprising steps of inputting an RF input signal to be amplified; outputting an amplified RF output signal, and tuning or configuring at least one tunable amplification parameter in accordance with at least one input parameter, wherein said tuning, or configuration of said at least one tunable amplification parameter is carried out by steering it by means of at least one neural network on the basis of said at least one input parameter input to said at least one neural network.

The description and drawings merely illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A power amplifier configured for amplifying an RF signal in a communication network, said power amplifier (A; 4) comprising:
- An RF signal input terminal (IN) for inputting an RF input signal (RFin) to be amplified by said power amplifier (A; 4),
- an RF signal output terminal (OUT) for outputting an RF output signal (RFout) amplified by said power amplifier (A; 4), and
- at least one tunable or configurable element (GB, DB),
wherein said power amplifier (A; 4) further comprises or is coupled with at least one neural network (NN; 10) configured to steer said at least one tunable or configurable element (GB, DB) on the basis of at least one input parameter (IP1 to IP5) input to said at least one neural network (NN; 10).

2. The power amplifier as claimed in claim 1, wherein said at least one tunable or configurable element (GB, DB) comprises one or more elements of a group consisting of: power amplifier's gate biasing modulation, power amplifier's drain biasing modulation, and switchable or tunable RF signal impedance or frequency matching network(s) of the power amplifier.

3. The power amplifier as claimed in claim 1, wherein said at least one input parameter (IP1 to IP5) to said at least one neural network (NN; 10) comprises one or more parameters of the group consisting of: RF input signal, RF output signal, number of RF carriers, number of signal channels, current load, signal properties, signal envelope, and time.

4. The power amplifier as claimed in claim 3, wherein said at least one neural network (NN;10) is configured to decide based on said input parameters about a required amplifier configuration by controlling said at least one tunable or configurable element (GB, DB).

5. The power amplifier as claimed in claim 3, wherein said at least one neural network (NN; 10) is configured to learn about current conditions or scenarios and to recognize conditions or scenarios for the future based on said at least one input parameter.

6. A base station (S1 to S6) comprising at least one power amplifier (A; 4) according to claim 1.

7. The base station as claimed in claim 6, further comprising one or more of the following additional functional units:
- A baseband signal processing unit (1),
- A digital signal processing unit (2, 8),
- at least one of a digital-to-analog and analog-to-digital conversion unit (3; 7),
- A low-noise amplifier (6),
wherein said at least one neural network (NN; 10) is coupled to said base station (S1 to S6) and configured for steering said at least one additional functional unit.

8. A communication network comprising at least two base stations (S1 - S6) as claimed in one of the claims 6 or 7, said base stations (S1 - S6) being configured to communicate together.

9. A communication network comprising:
- at least two base stations (S1 - S6) configured to communicate together, and
- at least one neural network (NN; NN1 - NN6) coupled to said at least two base stations (S1 - S6) and configured to tune or configure said base stations (S1 - S6) on the basis of at least one input parameter (IP1 to IP5) input to said at least one neural network (NN; NN1 to NN6).

10. A method for power amplification of an RF signal in a communication network, comprising steps of:
- Inputting an RF input signal (RFin) to be amplified;
- Outputting an amplified RF output signal (RFout), and
- tuning or configuring at least one tunable amplification parameter (GB, DB) in accordance with at least one input parameter (IP1 to IP5), wherein
- said tuning, or configuration of said at least one tunable amplification parameter (GB, DB) is carried out by steering it by means of at least one neural network (NN; 10) on the basis of said at least one input parameter input to said at least one neural network (NN;10).

11. The method for power amplification as claimed in claim 10, wherein said at least one tunable amplification parameter (GB, DB) comprises one or more parameters of a group consisting of: power amplifier's gate biasing modulation, power amplifier's drain biasing modulation, and switchable or tunable RF signal impedance or frequency matching.

12. the method for power amplification as claimed in claim 10, wherein said at least one input parameter (IP1 to IP5) to said at least one neural network (NN; 10) comprises one or more parameters of the group consisting of: RF input signal, RF output signal, number of RF carriers, number of signal channels, current load, signal properties, signal envelope, and time.

13. The method for power amplification as claimed in claim 12, wherein said at least one neural network (NN; 10) decides based on said input parameters about a required amplification configuration by controlling said at least one tunable or configurable parameter (GB, DB).

14. The method for power amplification as claimed in claim 12, wherein said at least one neural network (NN; 10) learns about current conditions or scenarios and recognizes conditions or scenarios for the future based on said at least one input parameter (IP1 to IP5).
